(19) Europäisches Patentamt

European Patent Office

Office européen des brevets

(11) EP 0 938 732 B1

(12) FASCICULE DE BREVET EUROPEEN

(45) Date de publication et mention
de la délivrance du brevet:
**11.07.2001 Bulletin 2001/28**

(51) Int Cl.$^7$: **G11C 27/02**

(21) Numéro de dépôt: **97945906.2**

(22) Date de dépôt: **12.11.1997**

(86) Numéro de dépôt international:
**PCT/FR97/02026**

(87) Numéro de publication internationale:
**WO 98/21726 (22.05.1998 Gazette 1998/20)**

(54) **CELLULE ELECTRONIQUE ANALOGIQUE, NOTAMMENT DESTINEE A ETRE IMPLANTEE DANS UN CIRCUIT INTEGRE, ET CIRCUIT INTEGRE COMPORTANT DE TELLES CELLULES**

ANALOGE ELEKTRISCHE ZELLE, INSBESONDERE ZUR IMPLANTIERUNG IN EINEN INTEGRIERTEN SCHALTKREIS UND INTEGRIERTER SCHALTKREIS DAMIT

ANALOG ELECTRONIC CELL, IN PARTICULAR DESIGNED TO BE IMPLANTED IN AN INTEGRATED CIRCUIT, AND INTEGRATED CIRCUIT COMPRISING SUCH CELLS

(84) Etats contractants désignés:
**AT BE CH DE ES FR GB IE IT LI PT**

(30) Priorité: **14.11.1996 FR 9614105**

(43) Date de publication de la demande:
**01.09.1999 Bulletin 1999/35**

(73) Titulaire: **INSTITUT NATIONAL DES SCIENCES APPLIQUEES DE LYON**
**(Etablissement public à caractère scientifique culturel et professionel)**
**F-69100 Villeurbanne (FR)**

(72) Inventeurs:
• **PREMONT, Christophe**
**F-38100 Grenoble (FR)**
• **BARREAULT, Gérard**
**F-69110 Sainte-Foy-les-Lyon (FR)**
• **GRISEL, Richard**
**F-76130 Mont-Saint-Aignan (FR)**

• **ABOUCHI, Nacer**
**F-69120 Vaulx-en-Velin (FR)**

(74) Mandataire: **Vuillermoz, Bruno**
**Cabinet Laurent & Charras**
**B.P. 32**
**20, rue Louis Chirpaz**
**69131 Ecully Cédex (FR)**

(56) Documents cités:
**EP-A- 0 450 863**        **US-A- 5 124 666**

• **PREMONT ET AL: "Current-conveyor based field programmable analog array" PROCEEDINGS 39TH MIDWEST SYMPOSIUM ON CIRCUITS AND SYSTEMS, vol. 1, 18 - 21 août 1996, NEW YORK, US, pages 155-157, XP002037395**
• **NANDI R ET AL: "PRECISE INSENTIVE CURRENT MODE VARIABLE GAIN ALLPASS FILTER USING CURRENT CONVEYORS" FREQUENZ, vol. 48, no. 9/10, 1 septembre 1994, pages 238-240, XP000479976**

## Description

## Domaine technique

L'invention concerne le domaine de l'électronique analogique. Elle vise plus précisément une cellule analogique élémentaire configurable apte à assurer une fonction transfert déterminée. L'invention vise aussi un circuit intégré incluant une pluralité de cellules élémentaires montées en réseau pour former un composant analogique programmable.

## Techniques antérieures

Dans le domaine des composants analogiques programmables, plusieurs solutions technologiques ont déjà été envisagées.

Ainsi, on connaît comme une première famille de composants électroniques dénommée EPAC correspondant à l'abréviation de la dénomination anglo-saxonne de « Electrically Programmable Analog Array Circuit ».

Ce type de composant se comporte comme un réseau analogique programmable dans lequel les différents signaux qui transitent sont discrétisés en vue de leur traitement digital, puis reconvertis en signaux analogiques. Ces composants fonctionnent en utilisant une technologie de capacités commutées. Leur fréquence de fonctionnement est donc relativement limitée à 120 kHz. Il est donc impossible avec de tels composants de réaliser les filtrages à des fréquences élevées.

Un premier problème que se propose donc de résoudre l'invention est celui de la limitation en fréquence de fonctionnement imposée par la technologie existante.

Par ailleurs, les composants du type EPAC fonctionnent en réalisant des traitements numériques qui sont donc consommateurs d'énergie, quelle que soit la valeur du signal à traiter. Ceci interdit donc l'utilisation de tels composants dans des applications nécessitant une relative autonomie énergétique, telle que par exemple la réalisation de filtrage de prothèses auditives.

Un second problème que se propose donc de résoudre l'invention est donc celui de la consommation électrique, et corollairement de l'autonomie énergétique de tels composants.

Par ailleurs, le document US 5 196 740 décrit un second type de composant analogique programmable. Ce composant est essentiellement basé sur l'association de cellules analogiques à base de structures d'amplificateurs opérationnels. Or, on sait que les structures à base d'amplificateurs opérationnels sont fortement consommatrices en terme de surface de silicium. Il n'est donc pas possible avec un tel circuit d'implanter un nombre suffisant de cellules élémentaires permettant la combinaison de fonctionnalités satisfaisantes.

Un troisième problème que se propose donc de résoudre l'invention est celui de la compacité des cellules élémentaires d'un composant analogique programmable.

En outre, le composant décrit dans le document précité fonctionne en utilisant une technologie de capacités commutées assurant un échantillonnage de certains signaux. Or, on sait que l'utilisation de telles capacités commutées induit des limitations en fréquence d'utilisation ainsi que des problèmes de non linéarité et de bruits.

L'invention pallie tous ces inconvénients, et vise à réaliser un composant analogique programmable fonctionnant à des fréquences élevées de l'ordre du MHz, qui présente une consommation faible, et de compacité satisfaisante.

## Exposé de l'invention

L'invention concerne donc tout d'abord une cellule électronique analogique élémentaire, notamment destinée à être implantée dans un circuit intégré analogique programmable, et comportant une borne d'entrée (E), une borne de sortie (S).

Cette cellule se caractérise en ce qu'elle comporte :

. une structure de convoyeur de courant présentant deux entrées (X,Y) et une sortie (Z), une des entrées (Y) étant reliée à la borne d'entrée (E) de la cellule, la sortie (Z) étant reliée à la borne de sortie (S) de la cellule ;

. deux circuits RC parallèles ($R_1,C_1$ ;$R_2,C_2$) connectés chacun d'une part respectivement à un potentiel de référence ($M_1$, $M_2$), et d'autre part, respectivement à l'entrée libre (X) du convoyeur de courant, et à la borne de sortie (S) de la cellule, les valeurs des résistances et capacités ($R_1,C_1$ ;$R_2,C_2$) étant réglables par voie électronique à des valeurs prédéterminées pour conférer à la cellule une fonction de transfert d'ordre 0 ou 1.

La structure de convoyeur de courant connue en soi, correspond à un schéma électronique à deux entrées (X, Y) et à une sortie (Z) dans laquelle les différentes tensions et courants ($V_X$, $V_Y$, $V_Z$,$I_X$, $I_Y$, $I_Z$) mesurées sur les bornes d'entrée et de sortie (X, Y, Z) vérifient les deux équations suivantes : $V_X = V_Y$ et $I_Y = \pm I_X$, regroupées dans la relation matricielle suivante :

$$\begin{bmatrix} I_Y \\ V_x \\ I_z \end{bmatrix} = \begin{bmatrix} 0 & 0 & 0 \\ 1 & 0 & 0 \\ 0 & \pm 1 & 0 \end{bmatrix} \times \begin{bmatrix} V_Y \\ I_X \\ V_Z \end{bmatrix}$$

Ainsi, grâce à cette structure de convoyeur de courant, et en fonction des différentes valeurs données aux résistances et aux capacités qui sont connectées aux différentes bornes du convoyeur de courant, on peut réaliser les principales fonctions analogiques. On peut citer par exemple des fonctions de source de tension ou de courant, de suiveur, d'amplificateur de tension ou de courant. On peut également réaliser des fonctions d'intégration ou de dérivation de tension. En jouant conjointement sur les valeurs des capacités des résistances on peut également obtenir des fonctions de filtrage passe-haut, passe-bas, passe-bande ou réjecteur de bande.

De façon plus générale, la fonction de transfert d'une telle cellule est la suivante :

$$F(s) = K \times \frac{1 + s\tau_1}{1 + s\tau_2}$$ où K représente le gain statique, $\tau_1$ et $\tau_2$ correspondant aux différentes fréquences de coupures des filtrés ainsi réalisés.

Ainsi, la structure de la cellule élémentaire est totalement analogique, ce qui lui permet de fonctionner à des fréquences plus élevées que celles permises avec les composants analogiques programmables de l'état antérieur qui incluent des traitements numériques.

L'utilisation d'une structure de convoyeur de courant consomme une surface de silicium réduite. On peut donc ainsi augmenter la densité de cellules élémentaires dans un circuit intégré comportant une pluralité de ces cellules montées en réseau.

Dans une première forme de réalisation, les potentiels de référence $M_1$ et $M_2$ sont connectés, de manière que la cellule fonctionne en mode commun.

Dans une seconde forme de réalisation, la cellule comporte un second convoyeur de courant lui permettant de fonctionner en mode différentiel. En pratique, la sortie du second convoyeur de courant est reliée au potentiel de référence $M_2$ et constitue la borne négative (S⁻) de la sortie différentielle, tandis qu'une des entrées (X) du second convoyeur de courant est reliée au potentiel de référence ($M_1$), et que l'autre entrée (Y) du second convoyeur de courant constitue la borne négative (E⁻) de l'entrée différentielle.

De la sorte, on s'affranchit de problèmes de tensions de décalage et bruits.

Pour faciliter l'intégration de telles cellules élémentaires dans un réseau analogique, dans une forme préférée de l'invention, cette cellule est bidirectionnelle, et constituée de deux cellules comme décrites précédemment, montées tête-bêche, les bornes d'entrée et de sortie de la première cellule étant reliées respectivement aux bornes de sortie et d'entrée de la seconde cellule.

Comme déjà dit, les résistances des circuits RC connectées aux différentes bornes des convoyeurs de courant sont réglables par voie électronique. Dans une première forme de réalisation, une des résistances réglables mesurées entre ses deux bornes respectivement inférieure et supérieure est réalisée par l'association de deux transistors mis en parallèle, et fonctionnant en régime ohmique, la grille d'un des transistors étant portée à un potentiel (+$V_C$) de commande par rapport à la borne inférieure de la résistance réglable, la grille de l'autre transistor étant portée au potentiel de commande opposé (-$V_C$) par rapport à la borne supérieure de la résistance réglable.

Dans une seconde forme de réalisation, assurant une meilleure linéarité de la valeur de la résistance, celle-ci est réalisée par l'association de deux transistors mis en série., et fonctionnant en régime ohmique, la borne d'un des transistors étant reliée à la tension d'alimentation positive (Vdd), une des bornes de l'autre transistor étant reliée à la tension d'alimentation négative (Vss), le point commun entre les deux transistors constituant la borne positive de la résistance réglable, la grille d'un des transistors étant portée à un potentiel de commande (Vn), la grille de l'autre transistor étant portée à un potentiel de commande (Vp) tel que $V_n - V_{Ton} = V_p - V_{Top}$., où $V_{ton}$ et $V_{top}$ sont les tensions de seuil des transistors.

Comme déjà dit, les capacités des circuits RC connectées aux différentes bornes des convoyeurs de courant sont également réglables.

Dans une première forme de réalisation, la capacité réglable, mesurée entre ces bornes respectivement supérieure ($C_1^+$) et inférieure ($C_1^-$) est constituée par :

. un premier convoyeur de courant monté en suiveur, dont une entrée est reliée à la borne supérieure ($C_1^+$) de la capacité réglable ;

. un second convoyeur de courant monté en amplificateur de courant, dont :

- une entrée est reliée à la sortie du premier convoyeur de courant et à une première résistance ($R_{C1}$) elle-même reliée au potentiel commun (M),

- l'autre entrée est reliée à une seconde résistance ($R_{C2}$), elle-même reliée au potentiel commun (M),

. une capacité fixe (C) dont une borne est reliée à la borne inférieure de la capacité réglable ($C_1^-$) et dont l'autre borne est conjointement reliée à la sortie du deuxième convoyeur de courant et à l'entrée libre du premier convoyeur de courant.

Dans ce cas, une des résistances reliées au second convoyeur de courant est réglable et réalisée comme décrit précédemment.

Dans une seconde forme de réalisation, la capacité réglable, mesurée entre ses bornes respectivement supérieure et inférieure est constituée par :

. un convoyeur de courant monté en amplificateur de courant dont :

. une entrée (X) est reliée à une première résistance, elle-même reliée au potentiel commun,

. la sortie (Z) est reliée à une seconde résistance, elle-même reliée au potentiel commun,

. l'entrée (Y) est reliée à la borne supérieure de la capacité réglable.

- une capacité fixe dont une borne est reliée à la borne supérieure de la capacité réglable, et dont l'autre borne est reliée à la sortie (Z) du convoyeur de courant.

Dans une forme préférée de l'invention, les convoyeurs de courant présentent des sources de polarisation contrôlable. Dans une première forme d'exécution, les deux sources de polarisation sont commandées simultanément pour conférer aux convoyeurs de courant une fonction de circuit ouvert ou de court circuit. De la sorte, une cellule convenablement commandée peut servir de pontage, ou à l'opposé d'interrupteur ouvert entre des cellules adjacentes.

Dans une seconde forme d'exécution, les deux sources de polarisation du convoyeur sont commandées indépendamment l'une de l'autre, de telle manière à implémenter les fonctions analogiques non -linéaires tel que le redressement, la multiplication, le logarithme et l'exponentiel.

Comme déjà dit, l'invention concerne également un circuit intégré analogique programmable. Ce circuit se <u>caractérise</u> en ce qu'il comporte:

- une pluralité de cellules élémentaires analogiques selon l'invention, interconnectées les unes aux autres pour former un réseau analogique, chacune des cellules comportant des composants actifs et des composants résistifs et capacitifs de valeur réglable pour conférer à chaque cellule une fonction de transfert d'ordre 0 ou 1.;
- des moyens pour régler selon des valeurs prédéterminées les grandeurs de chaque composant capacitif et/ou résistif.

En pratique, les cellules élémentaires analogiques implantées à l'intérieur du circuit analogique sont réalisées comme décrit précédemment. Néanmoins, l'invention couvre également des variantes de réalisation utilisant des cellules ne comprenant pas de convoyeur de courant, mais des moyens équivalents, pourvu que l'esprit de l'invention soit respecté, c'est-à-dire que les cellules soient purement analogiques, et contiennent des composants résistifs et capacitifs de valeur réglable par voie électronique.

En pratique, les moyens pour régler à des valeurs prédéterminées les grandeurs de chaque composant capacitif et/ou résistif sont constitués par :

- une mémoire numérique contenant des informations numériques correspondant aux valeurs prédéterminées des éléments capacitifs et résistifs ainsi qu'à l'état des sources de polarisation ;
- un convertisseur numérique/analogique transformant en valeur analogique les données de la mémoire numérique ;

- un multiplexeur analogique relié au convertisseur, et apte à alimenter les éléments résistifs et capacitifs, et les sources de polarisation des convoyeurs de courant des cellules élémentaires du réseau.

Dans une variante de réalisation éliminant au maximum les composants numériques, les moyens pour régler à des valeurs prédéterminées les valeurs de chaque composants capacitifs et résistifs sont constitués par une mémoire analogique effaçable (EEPROM), directement reliée aux éléments résistifs et capacitifs, et aux sources de polarisation des convoyeurs de courant des cellules élémentaires du réseau.

Comme déjà dit, les différentes cellules élémentaires sont destinées à être connectées au réseau.

Ainsi, dans une première forme de réalisation, les différentes cellules élémentaires sont interconnectées selon un réseau matriciel. Autrement dit, les différentes cellules connectées entre elles forment un maillage.

Selon une seconde approche, les différentes cellules élémentaires peuvent être interconnectées selon un réseau arborescent, systolique ou connexionniste, se rapprochant par là même de la topologie d'un réseau de neurones.

**Description sommaire des figures**

La manière de réaliser l'invention, ainsi que les avantages qui en découlent ressortiront bien de la description des modes de réalisation qui suivent, à l'appui des figures annexées dans lesquelles :

La figure 1 est un schéma de principe montrant une cellule élémentaire unidirectionnelle fonctionnant en mode commun.

La figure 2 est un schéma de principe montrant une cellule élémentaire unidirectionnelle fonctionnant en mode différentiel.

Les figures 3 et 4 sont des schémas de principe montrant une cellule élémentaire bidirectionnelle fonctionnant respectivement en mode commun et en mode différentiel.

La figure 5 est un schéma électronique montrant la structure interne d'un convoyeur de courant classique.

La figure 6 est un schéma électrique montrant la réalisation d'une résistance réglable conforme à l'invention.

La figure 7 est un schéma électronique représentant une forme préférée de réalisation d'une résistance réglable.

Les figures 8 et 9 sont des schémas électroniques illustrant deux réalisations de capacité réglable conforme à l'invention.

La figure 10 est un schéma montrant une cellule bidirectionnelle fonctionnant en gyrateur.

La figure 11 est un schéma de principe illustrant différentes cellules conformes à l'invention montées en réseau matriciel.

La figure 12 est un schéma de principe illustrant différentes cellules fonctionnant en mode différentiel montées en réseau matriciel.

La figure 13 est un schéma de principe montrant les différentes cellules conformes à l'invention interconnectées selon un réseau arborescent.

La figure 14 est un schéma de principe montrant les différents éléments composants un circuit intégré conforme à l'invention.

La figure 15 est un schéma de principe montrant une variante de la figure 8 utilisant une mémoire analogique.

## Manières de réaliser l'invention

Comme déjà dit, l'invention concerne d'une part, une cellule élémentaire analogique programmable, et d'autre part, un circuit intégré comportant une pluralité de cellules élémentaires interconnectées en réseau.

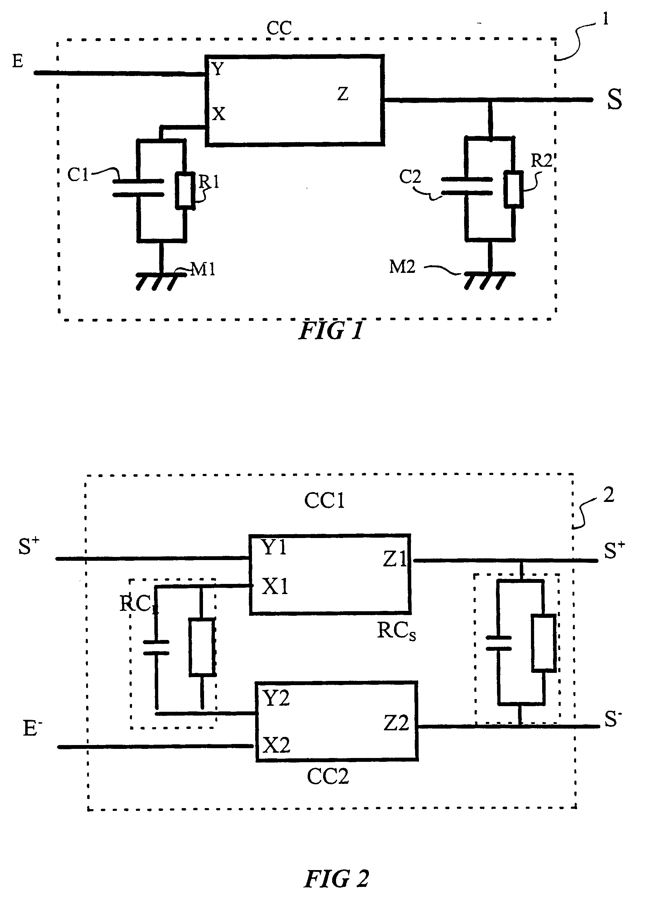

Une telle cellule élémentaire (1), comme représentée en figure 1, se compose essentiellement d'une structure de convoyeur de courant (CC) et de deux circuits RC parallèles ($R_1$,$C_1$, $R_2$, $C_2$) chargeant une entrée (X) et la sortie (Z) du convoyeur de courant (CC).

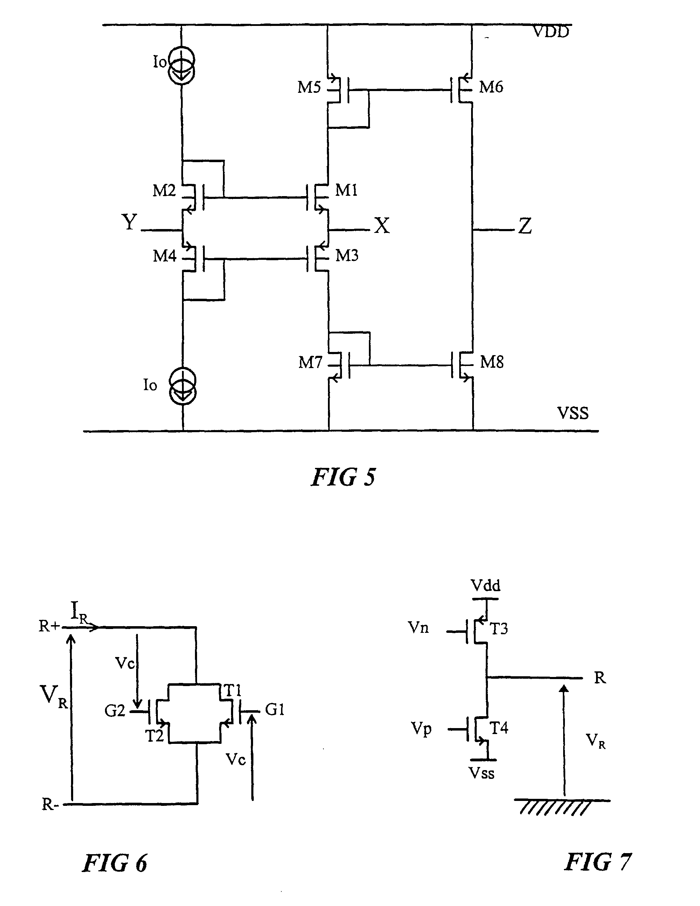

La structure de convoyeur de courant, connue en soi, ne sera pas décrite ici en détail. Néanmoins, elle peut être notamment réalisée selon un schéma électronique faisant l'objet de la figure 5, dans laquelle les éléments références $M_1$ à $M_8$ sont des transistors MOSFET et les sources de courant $I_0$ sont des sources de polarisation.

Un convoyeur de courant classique comporte deux entrées utiles (X, Y) très fortement impédantes et une sortie (Z) Le fonctionnement en « convoyeur de courant » correspond à d'une part, une fonction de suiveur de tension (équivalent à l'équation : $V_X = V_Y$), et d'autre part, une fonction de suiveur de courant (équivalent à l'équation $I_Z = \pm I_X$).

La structure de convoyeur de courant montée comme illustrée en figure 1, est connectée à divers éléments de la cellule élémentaire (1). Ainsi :

- une entrée (Y) de ce convoyeur de courant (CC) est reliée à la borne d'entrée (E) de la cellule ;
- l'autre entrée (X) du convoyeur de courant est reliée à un circuit RC parallèle ($R_1$, $C_1$) lui-même connecté au potentiel commun (M);
- la sortie (Z) du convoyeur de courant est reliée d'une part, à la sortie (S) de la cellule, et d'autre part, à un second circuit RC parallèle (R2, C2) lui-même également connecté au potentiel commun (M).

Ainsi, la fonction de transfert d'une telle cellule correspondante à $V_S/V_E$ est égale à : $F(s) = K \times \dfrac{1 + s\tau_1}{1 + s\tau_2}$ dans lequel :

- K correspond au gain statique, c'est-à-dire à $R_2/R_1$,
- les valeurs $\tau_1$ et $\tau_2$ correspondent respectivement aux constantes de temps des circuits $R_1$, $C_1$ et $R_2$, $C_2$

De la sorte, par le réglage des quatre composants résistifs et capacitifs $R_1$, $C_1$, $R_2$, $C_2$, il est possible de conférer à la fonction de transfert une pluralité de fonctions de transfert d'ordre 0 ou 1. On peut citer de façon exemplative et non limitative les fonctions de suiveur, d'amplificateur inverseur, d'intégrateur, de dérivateur, de filtre passe-haut, passe-bas, passe-bande ou réjecteur de bande.

Comme déjà dit, pour s'affranchir des problèmes de bruits et de tension d'offset, il peut s'avérer avantageux de donner à la cellule élémentaire une architecture symétrique, et permettant de fonctionner en mode différentiel. Plus précisément, comme on le voit à la figure 2, une telle structure se compose de deux convoyeurs de courant ($CC_1$ et $CC_2$). Le premier convoyeur de courant ($CC_1$) présente une entrée ($Y_1$) reliée à la borne positive ($E^+$) de la cellule, la sortie ($Z_1$) du convoyeur de courant ($CC_1$) est relié à la borne supérieure ($S^+$) de la sortie de la cellule. Symétriquement, le second convoyeur de courant ($CC_2$) présente une entrée ($X_2$) directement reliée à la borne inférieure ($E^-$) de l'entrée de la cellule tandis que la sortie ($Z_2$) du convoyeur ($CC_2$) est reliée à la borne négative ($S^-$) de sortie de la cellule. Les deux convoyeurs ($CC_1$ et $CC_2$) sont reliés par deux circuits RC caractéristiques ($RC_E$, $RC_S$).

Ainsi, un premier circuit ($RC_E$) relie les entrées ($X_1$) et ($Y_2$) respectivement du premier convoyeur de courant ($CC_1$) du second ($CC_2$). De l'autre côté, les bornes de sortie de la cellule et donc les deux sorties ($Z_1$, $Z_2$) des convoyeurs ($CC_1$,$CC_2$) sont pontées par un second circuit RC ($RC_S$). Cette architecture correspond à la symétrisation par rapport à un potentiel moyen fictif d'une cellule de base comme illustrée à la figure 1.

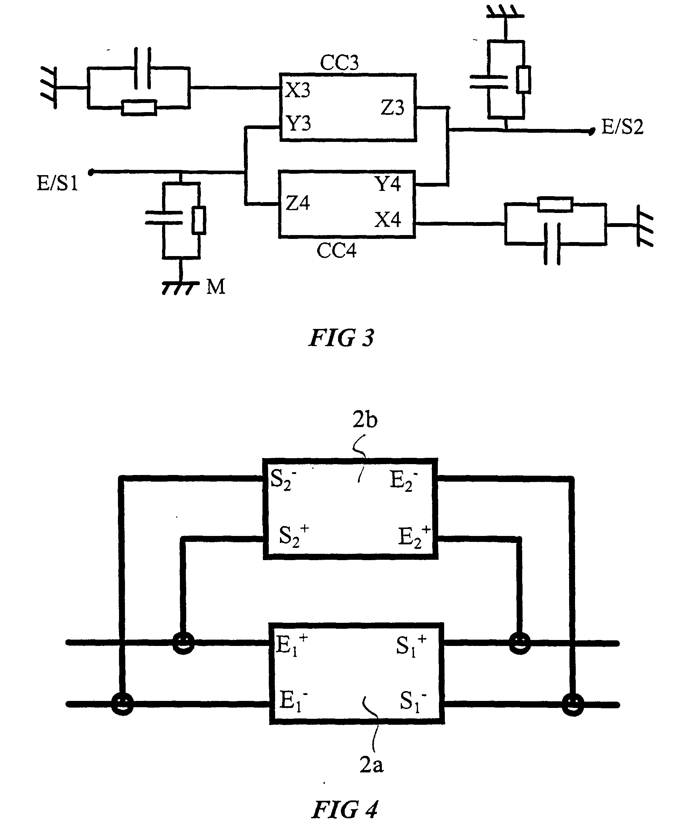

Comme déjà dit, pour assurer une bidirectionnalité à une cellule élémentaire conforme à l'invention, il peut être avantageux d'associer deux cellules élémentaires telles que décrites et illustrées dans la figure 1, pour les monter tête-bêche comme illustré à la figure 3. Plus précisément, une des entrées $Y_3$ du premier convoyeur de courant $CC_3$ est reliée à la sortie $Z_4$ du second convoyeur de $CC_4$, ces deux points étant eux-mêmes reliés à une borne $ES_1$ servant d'entrée/sortie de la cellule globale (1).

Symétriquement, la sortie $Z_3$ du premier convoyeur de courant $CC_3$ est connecté à l'entrée $X_4$ du second convoyeur de courant $CC_4$, ces deux points étant également connectés à une seconde borne d'entrée/sortie $ES_2$.

Comme pour les cellules unidirectionnelles,

les entrées $X_3$ et $X_4$ des convoyeurs de courant $CC_3$, $CC_4$ sont reliées par deux circuits RC à un potentiel commun (M). Les sorties de chaque convoyeur de courant sont également reliées chacune à un circuit RC lui-même relié au potentiel commun (M).

Comme on le verra dans la suite, lorsque les cellules élémentaires (3) sont destinées à être interconnectées en réseau, chacun des circuits RC connecté aux bornes d'entrée/sortie de chaque cellule, est partagé avec les cellules adjacentes.

De la même manière que pour les cellules fonctionnant en mode commun, les cellules en version différentielle peuvent être montées tête-bêche pour être bidirectionnelles. Ainsi, comme on le voit schématiquement à la figure 4, deux cellules (2) équivalentes à celles représentées à la figure 2 sont montées tête-bêche, les sorties ($S_1^+$) et ($S_1^-$) de la première cellule de A étant connectées, en respectant la polarité aux entrées ($E_2^+$) et ($E_2^-$) de la cellule 2B. Symétriquement, les sorties ($S_2^+$) et ($S_2^-$) de la cellule 2B sont reliées aux entrées ($E_1^+$) et ($E_1^-$) de la cellule 2A.

Selon une des caractéristiques essentielles de l'invention, chacun des composants des différents circuits RC connectés aux convoyeurs de courant sont réglables par voie électronique, c'est-à-dire que leur valeur peut être contrôlée par un signal de commande.

Ainsi, dans une première forme de réalisation, les résistances sont constituées comme illustrée à la figure 6. Plus précisément, le circuit présente un comportement équivalent à celui d'une résistance en ce sens que le courant $I_R$ qui le traverse est proportionnel à la tension $V_R$ mesurée entre ses bornes positive $R^+$ et négative $R^-$. En pratique, ce comportement résistif est obtenu grâce à l'association de deux transistors MOS ($T_1$, $T_2$) montés en parallèle, et polarisés en régime ohmique.

La valeur de la résistance est ajustée par le potentiel de commande ($V_C$) appliqué aux grilles de chacun de ces transistors (T).

Ainsi, le premier transistor ($T_1$) voit sa grille ($G_1$) portée un potentiel $V_C$ par rapport à la borne inférieure $R^-$ de la résistance. La grille ($G_2$) de l'autre transistor ($T_2$) est portée au potentiel $-V_C$ par rapport à la borne supérieure $R^+$ de la résistance.

Plus précisément, la valeur de la résistance est donnée par la formule suivante :

$$\frac{1}{2.\mu.Cox.\dfrac{W}{L}.(V_C - V_T)}.$$

dans laquelle :

- $\mu$ est la mobilité,
- $C_{ox}$ est la capacité surfacique d'oxyde de grille,
- W est la largeur du canal du transistor,
- $V_T$ est la tension de seuil du transistor

En juxtaposant plusieurs résistances ainsi configurables on obtient une série de plages de valeurs.

Avantageusement, on choisit des plages successives formant des calibres, par exemple de 1 kΩ à 10 kΩ, puis de 10 à 100 kΩ, et de 100 kΩ à 1 MΩ.

La fréquence réponse au signal de commande d'une telle résistance est rapide, et supérieure à 10 MHz.

Dans une seconde forme de réalisation, la résistance peut être obtenue selon le montage objet de la figure 7. Ce montage est constitué par deux transistors MOS ($T_3$, $T_4$) montés en série, un des transistors ($T_3$) étant connecté à la source d'alimentation positive (Vdd), tandis que l'autre transistor ($T_4$) à une de ses bornes reliées à la source d'alimentation négative (Vss). Le point commun de ces deux transistors constitue la borne positive de la résistance équivalente, le potentiel commun (M) constituant la borne négative de la résistance équivalente. La valeur de la résistance est ajustée par le potentiel de commande (Vn, Vp) appliqué aux grilles de chacun des transistors. Le premier transistor ($T_3$) voit sa grille ($G_3$) portée au potentiel (Vn) par rapport à la borne inférieure ($R^-$) de la résistance. La grille ($G_2$) de l'autre transistor ($T_4$) est portée au potentiel (Vp) également par rapport à la borne inférieure de la résistance. La valeur de la résistance est alors donnée par :

$$\frac{1}{2.\mu.Cox.\dfrac{W}{L}.(V_n - V_{Ton})}.,$$

avec les mêmes conventions que pour la forme décrite précédemment.

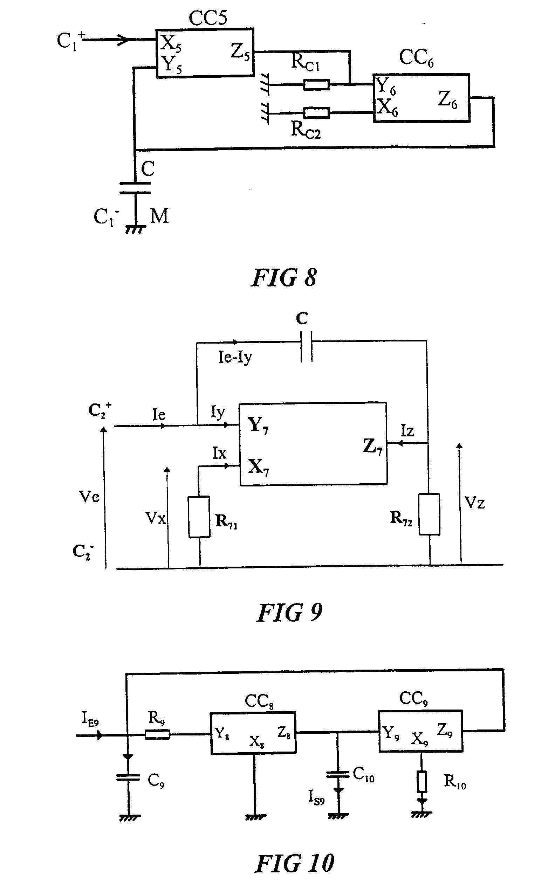

Comme déjà dit, les composants capacitifs connectés aux différents convoyeurs de courant peuvent être également réglables, par voie électronique. La figure 8 illustre un montage assurant un tel réglage. Ainsi, la capacité équivalente, mesurée entre ces deux bornes, respectivement supérieure $C_{1+}$ et inférieure $C_{1-}$ est constituée par :

- un premier convoyeur de courant $CC_5$ :

  . monté en suiveur, dont une entrée $X_5$ est reliée à la borne supérieure ($C_1^+$) de la capacité réglable ;
  . un second convoyeur de courant $CC_6$ monté en amplificateur de courant, dont :

    - une entrée $Y_6$ est reliée à la sortie $Z_5$ du premier convoyeur de courant $CC_5$ et à une première résistance ($R_{C1}$) elle-même reliée au potentiel commun (M),
    - l'autre entrée $X_6$ est reliée à une seconde résistance ($R_{C2}$), elle-même reliée au potentiel commun (M),

  . une capacité fixe (C) dont une borne est reliée à la borne inférieure de la capacité réglable $(C_1^-)$ et dont l'autre borne est conjointement reliée à la sortie $Z_6$ du deuxième convoyeur de courant et à l'entrée libre $Y_5$ du premier convoyeur de courant .

L'impédance d'un tel montage, mesurée entre les bornes C1$^+$ et C1$^-$ est donc égale à celle de la capacité fixe C multipliée par le gain de l'amplificateur de courant, soit R1/R2. Ce gain est réglé grâce à l'utilisation d'une des deux résistances $R_1$ ou $R_2$ réglable, implantées conformément à l'un des schémas de résistance variable décrits ci-avant.

La capacité réglable est réalisée selon une seconde architecture illustrée à la figure 9. Ainsi cette capacité réglable est basée selon un principe de multiplieur capacitif à base de convoyeur de courant. Plus précisément, le convoyeur de courant $(CC_7)$ présente une entrée reliée $(Y_7)$ à la borne supérieure $(C_2^+)$ de la capacité réglable équivalente. La borne inférieure $(C_2^-)$ de la capacité réglable équivalente au potentiel commun (M) de l'amplificateur de courant. L'autre entrée $(X_7)$ du convoyeur de courant $(CC_7)$ est reliée au potentiel commun (M) par l'intermédiaire d'une résistance $(R_{71})$ de valeur fixe. La sortie $(Z_7)$ du convoyeur de courant est reliée d'une part, au potentiel commun (M) via une résistance réglable $(R_{72})$ et d'autre part, à l'entrée $(Y_7)$ du convoyeur de courant, c'est-à-dire la borne supérieure de la capacité $(C_2^+)$ réglable. Dans les gammes de fréquence nous intéressant, les impédances internes des cellules sont négligeables et l'impédance apparente d'une telle structure, entre les bornes $(C_1^+, C_1^-)$ correspond donc à celle de la capacité fixe ( C ) multipliée par un gain réglable en fonction de la valeur de $R_{71}$ ou $R_{72}$.

En pratique, on obtient des capacités variables dans une plage allant de 10 picoFarads à 4 nanoFarads.

Comme déjà dit, les structures de convoyeur de courant présentent au moins deux sources de polarisation. Dans une variante de réalisation, non représentée il peut s'avérer avantageux de commander simultanément ces différentes sources de polarisation pour donner au convoyeur de courant un comportement de circuit ouvert, induisant ainsi une séparation des différentes cellules adjacentes lorsque celles-ci sont montées en réseau, ou de court-circuit pour assurer une connexion entre deux cellules quasi adjacentes d'un réseau. On peut également commander les sources de polarisation indépendamment pour donner à la cellule une fonction non linéaire, telle que redresseur, multiplication.

Une cellule bidirectionnelle, comme illustré à la figure 3 peut également présenter une fonction de transfert du second ordre du type gyrateur. La figure 10 illustre une telle cellule dans laquelle les convoyeurs de courant ont été représentés l'un derrière l'autre pour faciliter la compréhension. Plus précisément, le circuit RC connecté à la borne d'entrée (29) de la cellule, est constitué uniquement par une capacité seule. La résistance $R_9$ en série avec l'entrée $Y_8$ du convoyeur de courant (8) correspond à la résistance interne de l'entrée $(Y_8)$ du convoyeur de courant. L'entrée $(X_8)$ du convoyeur de courant $(CC_8)$ est connectée au potentiel commun (M). Le circuit RC connecté à l'entrée $(X_9)$ du convoyeur de courant $(CC_9)$ est constitué uniquement par une résistance $(R_{10})$. Le circuit RC connecté à la sortie (S) de la cellule, c'est-à-dire à l'entrée $(Y_9)$ du convoyeur de courant $(CC_9)$ est elle constituée par une seule capacité $(C_{10})$. La borne de transfert en courant d'une telle cellule est donc deuxième ordre et plus précisément la suivante. :

$$\frac{IE_9}{IS_9}=F(s) = -\frac{R_{10}.C_{10}.p}{1+R_{10}.C_{10}.s+R_9.R_{10}.C_{10}.C_9.s^2}$$

Comme déjà dit, l'invention concerne également un circuit électronique intégré analogique programmable. Un tel circuit analogique programmable présente de façon essentielle une pluralité de cellules élémentaires purement analogiques interconnectées les unes aux autres sous forme d'un réseau analogique. Chacune des cellules présentent notamment des composants résistifs et capacitifs de valeur réglable permettant de conférer à chacune des cellules des fonctions de transfert simples, c'est-à-dire d'ordre 0 ou 1. L'association de ces différentes cellules entre elles permet de donner au réseau une fonction de transfert globale complexe, et résultant de l'association de fonctions de transfert élémentaires.

L'utilisation de cellules purement analogiques, excluant tout type d'opération numérique permet le fonctionnement à des fréquences très élevées, de l'ordre du MegaHertz.

Selon une caractéristique essentielle, le circuit intégré comporte des moyens pour régler selon des valeurs prédéterminées les grandeurs de chaque composants capacitifs et/ou résistifs.

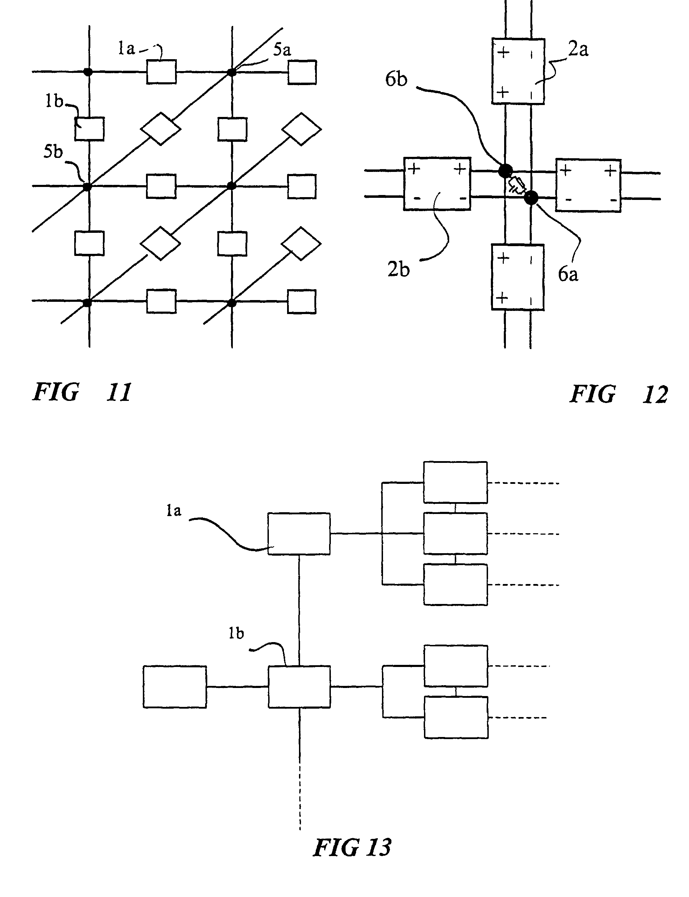

Dans une première forme de réalisation illustrée à la figure 11, les différentes cellules élémentaires (1.a, 1.b) sont interconnectées sous forme d'un réseau matriciel. Ainsi, ce réseau comporte une pluralité de noeuds (5a, 5b) formant un quadrillage matriciel. Les différents noeuds adjacents sont chacun reliés par des cellules élémentaires. Comme déjà dit, les différentes cellules reliées au niveau d'un noeud commun partagent un des circuits RC relié en sortie d'un des convoyeurs de courant.

La figure 12 illustre le même type de topologie de réseau avec des cellules différentielles. Dans ce cas, les circuits RC reliant les bornes de sortie d'une cellule différentielle (équivalente au circuit $RC_S$ de la figure 2) sont partagés au niveau des deux (6a, 6b) d'un tel réseau.

La topologie sous forme de réseau matriciel permet notamment de traiter avantageusement les cas où plusieurs signaux doivent être traités parallèlement, puis intégrés dans des boucles de rétroaction. Les liaisons au niveau de chacun des noeuds permettent d'utiliser les cellules élémentaires pour assurer des fonctions de sommation de signaux.

La topologie matricielle s'avère avantageuse dans l'application au prototypage et/ou l'implantation de fonctions analogiques. Elle permet également de traiter des fonctions analogiques multicanaux, c'est-à-dire utilisant ce parallélisme.

Selon une autre forme de réalisation, les cellules peuvent être organisées sous forme d'un réseau arborescent comme illustré à la figure 13. Une telle topologie peut donner lieu à un fonctionnement du type « réseau de neurones ».

En effet, la structure élémentaire d'une cellule permet de réaliser entre l'entrée et la sortie un court-circuit ou un circuit ouvert, ou une fonction de transfert programmable de l'entrée vers la sortie ou inversement. L'interconnexion de telles cellules entre elles permet de réaliser pour le traitement du signal, le traitement et la reconnaissance de la parole, le traitement d'images et la reconnaissance de formes, des opérations traitables par des structures organisées en réseaux de neurones. Les opérations ainsi traitables sont par exemple la corrélation, l'auto-organisation matricielle, la classification, l'apprentissage et l'auto-apprentissage ... etc. La structure de cellule conforme à l'invention s'adapte donc bien aux architectures matricielles, arborescentes, systoliques, connexionniste ou autre.

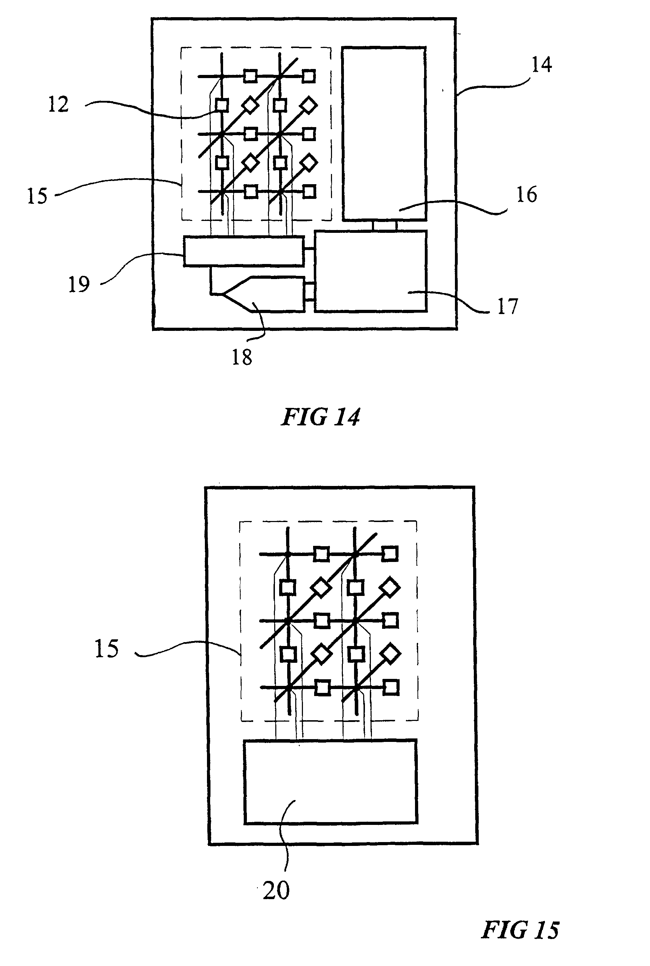

Le réseau(15) de cellules élémentaires (12) peut être commandé comme illustré à la figure 14. Ainsi, le circuit intégré (14) présente donc un réseau (15) de cellules élémentaires et des moyens de commande constitués par une mémoire numérique (16) contenant les informations correspondantes aux valeurs prédéterminées des éléments capacitifs et résistifs, ainsi que l'état des différentes sources de polarisation de chacune des cellules élémentaires. Cette mémoire (16) peut être programmée, de manière connue en soi.

Cette mémoire (16) est associée à une unité logique de contrôle (17) apte à sélectionner les différentes informations contenues dans la mémoire numérique (16). Cette unité logique de contrôle (17) alimente un convertisseur digital/analogique (18) pour transformer les informations numériques en signaux analogiques correspondants notamment aux tensions de commande des différentes résistances et capacités réglables décrites ci-avant. Le convertisseur digital/analogique (18) alimente un multiplexeur analogique (19) qui aiguille le signal analogique ainsi créé en direction de la cellule (12), et plus précisément de la résistance variable ou de la source de polarisation visée.

Dans une forme de réalisation différente, illustrée à la figure 15, une mémoire analogique (20) alimente directement les différents composants réglables de chacune des cellules, sans qu'il soit nécessaire d'utiliser de multiplexeur ni de convertisseur numérique analogique.

Un composant analogique programmable conforme à l'invention présente de très nombreuses applications. Il peut notamment être utilisé pour réaliser des éléments de filtrage analogique de très petites dimensions, comme par exemple des prothèses auditives. Il peut être également utilisé pour interface des capteurs de mesure ou assurer des fonctions de régulation.

La cellule élémentaire analogique, et son application à la réalisation d'un réseau analogique programmable au sein d'un circuit intégré présente entre autres les avantages suivants :

- l'unicité de la structure de cellules de base pour assurer de multiples fonctions de transfert ;
- une densité relativement élevée permettant typiquement d'implanter cent cellules élémentaires dans une surface de 4 mm$^2$ ;
- une consommation énergétique fonction uniquement du nombre de cellules utilisées ;
- une très large bande passante due à l'utilisation d'une cellule purement analogique.

**Revendications**

1. Cellule électronique analogique élémentaire unidirectionnelle, notamment destinée à être implantée dans un circuit intégré analogique programmable, et comportant une borne d'entrée (E), une borne de sortie (S) <u>caractérisée</u> en ce qu'elle comporte :

   . une structure de convoyeur de courant présentant deux entrées (X,Y) et une sortie (Z), une des entrées (Y) étant reliée à la borne d'entrée (E) de la cellule, la sortie (Z) étant reliée à la borne de sortie (S) de la cellule ;
   . deux circuits RC parallèles ($R_1,C_1$ ;$R_2,C_2$) connectés chacun d'une part respectivement à un potentiel de référence ($M_1$, $M_2$), et d'autre part, respectivement à l'entrée libre (X) du convoyeur de courant, et à la borne de sortie (S) de la cellule, les valeurs des résistances et capacités ($R_1,C_1$ ;$R_2,C_2$) étant réglables par voie électronique à des valeurs prédéterminées pour conférer à la cellule une fonction de transfert d'ordre 0 ou 1.

2. Cellule électronique analogique élémentaire unidirectionnelle selon la revendication 1, <u>caractérisée</u> en ce que les potentiels de référence $M_1$ et $M_2$ sont connectés, de manière que la cellule fonctionne en mode commun.

3. Cellule électronique analogique élémentaire unidirectionnelle selon la revendication 1, <u>caractérisée</u> en ce qu'elle comporte un second convoyeur de courant lui permettant de fonctionner en mode différentiel, la sortie (Z) du second convoyeur de courant étant reliée au potentiel de référence $M_2$ et constituant la borne négative (S⁻) de la sortie différentielle, une des entrées (X) du second convoyeur de courant étant reliée au potentiel de référence ($M_1$), l'autre entrée (Y) du second convoyeur de courant constituant la borne négative E⁻ de l'entrée différentielle.

4. Cellule électronique analogique élémentaire bidirectionnelle, notamment destinée à être implantée dans un circuit intégré analogique programmable, <u>caractérisée</u> en ce qu'elle est constituée de deux cellules selon l'une des revendications 1 à 3, montées tête-bêche, les bornes d'entrée ($E_1$) et de sortie ($S_1$) de la première cellule étant reliées respectivement aux bornes de sortie ($S_2$) et d'entrée ($E_2$) de la seconde cellule.

5. Cellule selon l'une des revendications 1 à 4, <u>caractérisée</u> en ce qu'une des résistances réglables ($R_1$, $R_2$), mesurées entre ses deux bornes respectivement inférieure ($R_1^-$), et supérieure ($R_1^+$), est réalisée par l'association de deux transistors mis en parallèle, et fonctionnant en régime ohmique, la grille d'un des transistors étant portée à un potentiel ($+V_C$) de commande par rapport à la borne inférieure ($R_1^-$) de la résistance réglable, la grille de l'autre transistor étant portée au potentiel de commande opposé ($-V_C$) par rapport à la borne supérieure ($R_1^+$) de la résistance réglable.

6. Cellule selon l'une des revendications 1 ou 4, <u>caractérisée</u> en ce que l'une des résistances réglables ($R_1$, $R_2$), mesurées entre ses deux bornes respectivement inférieure ($R_1^-$), et supérieure ($R_1^+$), est réalisée par l'association de deux transistors mis en série, et fonctionnant en régime ohmique et de tensions de seuil ($V_{TOM}$, $V_{TOP}$) la borne d'un des transistors ($T_3$) étant reliée à l'alimentation positive (Vdd), une des bornes de l'autre transistor ($T_4$) étant reliée à l'alimentation négative (Vss), le point commun entre les deux transistors ($T_3$, $T_4$) constituant la borne positive ($R_1^+$) de la résistance réglable, la grille du transistor ($T_4$) étant portée à un potentiel (Vn) de commande, la grille de l'autre transistor étant portée à un potentiel de commande (Vp) tel Vn - Vton = Vp - Vtop.

7. Cellule selon l'une des revendications 1 à 6, <u>caractérisée</u> en ce que :

 - la capacité réglable, mesurée entre ses bornes respectivement supérieure ($C_1^+$) et inférieure ($C_1^-$) est constituée par :

 . un premier convoyeur de courant monté en suiveur, dont une entrée est reliée à la borne supérieure ($C_1^+$) de la capacité réglable ;

 . un second convoyeur de courant monté en amplificateur de courant, dont :

 - une entrée est reliée à la sortie du premier convoyeur de courant et à une première résistance ($R_{C1}$) elle-même reliée au potentiel commun (M),
 - l'autre entrée est reliée à une seconde résistance ($R_{C2}$), elle-même reliée au potentiel commun (M),

 . une capacité fixe (C) dont une borne est reliée à la borne inférieure de la capacité réglable ($C_1^-$) et dont l'autre borne est conjointement reliée à la sortie du deuxième convoyeur de courant et à l'entrée libre du premier convoyeur de courant ;

 - et en ce qu'une des résistances ($R_{C1}$, $R_{C2}$) reliées au second convoyeur de courant est réglable et réalisée selon la revendication 3.

8. Cellule selon l'une des revendications 1 à 6, <u>caractérisée</u> en ce que la capacité réglable, mesurée entre ses bornes respectivement supérieure ($C_1^+$) et inférieure ($C_1^-$) est constituée par :

 . un convoyeur de courant monté en amplificateur de courant dont :

 . une entrée (X) est reliée à une première résistance ($R_1$), elle-même reliée au potentiel commun (M),
 . la sortie (Z) est reliée à une seconde résistance ($R_2$), elle-même reliée au potentiel commun (M),
 . l'entrée (Y) est reliée à la borne supérieure ($C_1^+$) de la capacité réglable.

 . une capacité fixe (C ) dont une borne est reliée à la borne supérieure (C1+) de la capacité réglable, et dont l'autre borne est reliée à la sortie (Z) du convoyeur de courant.

9. Cellule selon l'une des revendications 1 à 8, <u>caractérisée</u> en ce que les convoyeurs de courant présentent des sources de polarisation ($I_0$) commandée simultanément pour conférer à la cellule une fonction de circuit ouvert ou de court-circuit.

10. Cellule selon l'une des revendications 1 à 8, <u>caractérisée</u> en ce que les convoyeurs de courant présentent des sources de polarisation ($I_0$) commandées indépendamment pour conférer à la cellule une fonction non linéaire.

**11.** Circuit électronique intégré analogique programmable, <u>caractérisé</u> en ce qu'il comporte :

- une pluralité de cellules élémentaires analogiques réalisées selon une des revendications 1 à 10, interconnectées les unes aux autres pour former un réseau analogique, chacune des cellules comportant des composants actifs et des composants résistifs et capacitifs de valeur réglable pour conférer à chaque cellule une fonction de transfert d'ordre 0 ou 1 ;
- des moyens pour régler selon des valeurs prédéterminées les grandeurs de chaque composant capacitif et/ou résistif.

**12.** Circuit intégré électronique analogique programmable selon la revendication 11, <u>caractérisé</u> en ce que les moyens pour régler à des valeurs prédéterminées les grandeurs de chaque composant capacitif et/ou résistif sont constitués par :

- une mémoire numérique (16) contenant des informations numériques correspondant aux valeurs prédéterminées des éléments capacitifs et résistifs ainsi qu'à l'état des sources de polarisation ;
- un convertisseur numérique/analogique (18) transformant en valeur analogique les données de la mémoire numérique ;
- un multiplexeur analogique (19) relié au convertisseur (18), et apte à alimenter les éléments résistifs et capacitifs, et les sources de polarisation des convoyeurs de courant des cellules élémentaires (12) du réseau (15).

**13.** Circuit intégré électronique analogique programmable selon l'une des revendications 11 ou 12, <u>caractérisé</u> en ce que les moyens pour régler à des valeurs prédéterminées les valeurs de chaque composants capacitifs et résistifs sont constitués par une mémoire analogique effaçable (EEPROM) (20), directement reliée aux éléments résistifs et capacitifs, et aux sources de polarisation des convoyeurs de courant des cellules élémentaires (12) du réseau (15).

**14.** Circuit intégré électronique analogique programmable selon l'une des revendications 11 à 13, <u>caractérisé</u> en ce que les différentes cellules élémentaires (2) sont interconnectées selon un réseau matriciel.

**15.** Circuit intégré électronique analogique programmable selon l'une des revendications 11 à 13, <u>caractérisé</u> en ce que les différentes cellules élémentaires (2) sont interconnectées selon un réseau arborescent.

**Claims**

**1.** Unidirectional elementary analogue electronic cell, intended in particular to be implanted in a programmable analogue integrated circuit, and comprising an input terminal (E), an output terminal (S) <u>characterized</u> in that it comprises:

. a current conveyor structure having two inputs (X, Y) and an output (Z), one of the inputs (Y) being connected to the input terminal (E) of the cell, the output (Z) being connected to the output terminal (S) of the cell;

. two parallel RC circuits ($R_1$, $C_1$; $R_2$, $C_2$) each linked on the one hand respectively to a reference potential ($M_1$, $M_2$), and on the other hand, respectively to the free input (X) of the current conveyor, and to the output terminal (S) of the cell, the values of the resistors and capacitors ($R_1$, $C_1$; $R_2$, $C_2$) being electronically adjustable to predetermined values so as to afford the cell a transfer function of order 0 or 1.

**2.** Unidirectional elementary analogue electronic cell according to Claim 1, <u>characterized</u> in that the reference potentials ($M_1$, $M_2$) are linked, in such a way that the cell operates in common mode.

**3.** Unidirectional elementary analogue electronic cell according to Claim 1, <u>characterized</u> in that it comprises a second current conveyor allowing it to operate in differential mode, the output (Z) of the second current conveyor being connected to the reference potential $M_2$ and constituting the negative terminal ($S^-$) of the differential output, one of the inputs (Y) of the second current conveyor being connected to the reference potential ($M_1$), the other input (Y) of the second current conveyor constituting the negative terminal ($E^-$) of the differential input.

**4.** Bidirectional elementary analogue electronic cell, intended in particular to be implanted in a programmable analogue integrated circuit, <u>characterized</u> in that it consists of two cells according to one of Claims 1 to 3, mounted head-to-tail, the input terminal ($E_1$) and output terminal ($S_1$) of the first cell being connected respectively to the output terminal ($S_2$) and the input terminal ($E_2$) of the second cell.

**5.** Cell according to one of Claims 1 to 4, <u>characterized</u> in that one of the adjustable resistors ($R_1$, $R_2$), measured between its two terminals, respectively lower ($R_1^-$) and upper ($R_1^+$), is produced by amalgamating two transistors placed in parallel and operating in an ohmic regime, the gate of one of the transistors being taken to a control potential ($+V_C$) with respect to the lower terminal ($R_1^-$) of the adjustable resistor, the gate of the other transistor being taken to the opposite control potential ($-V_C$) with respect to the upper terminal ($R_1^+$) of the adjustable resistor.

6. Cell according to one of Claims 1 or 4, <u>characterized</u> in that one of the adjustable resistors ($R_1$, $R_2$), measured between its two terminals, respectively lower ($R_1^-$) and upper ($R_1^+$), is produced by amalgamating two transistors placed in series and operating in an ohmic regime, and threshold voltages ($V_{TOM}$, $V_{TOP}$) the terminal of one of the transistors ($T_3$) being connected to the positive supply (Vdd), one of the terminals of the other transistor ($T_4$) being connected to the negative supply (Vss), the common point between the two transistors ($T_3$, $T_4$) constituting the positive terminal ($R_1^+$) of the adjustable resistor, the gate of the transistor ($T_4$) being taken to a control potential (Vn), the gate of the other transistor being taken to a control potential (Vp) such that Vn - Vton = Vp - Vtop.

7. Cell according to one of Claims 1 to 6, <u>characterized</u> in that:

   - the adjustable capacitor, measured between its respectively upper ($C_1^+$) and lower ($C_1^-$) terminals consists of:

      . a first current conveyor mounted in follower mode, one input of which is connected to the upper terminal ($C_1^+$) of the adjustable capacitor;
      . a second current conveyor mounted as a current amplifier, in which:

         - one input is connected to the output of the first current conveyor and to a first resistor ($R_{C1}$) itself connected to the common potential (M),
         - the other input is connected to a second resistor ($R_{C2}$), itself connected to the common potential (M),

      . a fixed capacitor (C), one terminal of which is connected to the lower terminal of the adjustable capacitor ($C_1^-$) and the other terminal of which is jointly connected to the output of the second current conveyor and to the free input of the first current conveyor;

         - and in that one of the resistors ($R_{C1}$, $R_{C2}$) connected to the second current conveyor is adjustable and produced according to Claim 3.

8. Cell according to one of Claims 1 to 6, <u>characterized</u> in that the adjustable capacitor, measured between

its respectively upper ($C_1^+$) and lower ($C_1^-$) terminals consists of:

   . a current conveyor mounted as a current amplifier in which:
   . one input (X) is connected to a first resistor ($R_1$), itself connected to the common potential (M),
   . the output (Z) is connected to a second resistor ($R_2$), itself connected to the common potential (M),
   . the input (Y) is connected to the upper terminal ($C_1^+$) of the adjustable capacitor,
   . a fixed capacitor (C), one terminal of which is connected to the upper terminal ($C_1^+$) of the adjustable capacitor, and the other terminal of which is connected to the output (Z) of the current conveyor.

9. Cell according to one of Claims 1 to 8, <u>characterized</u> in that the current conveyors have bias sources ($I_0$) controlled simultaneously so as to afford the cell an open-circuit or short-circuit function.

10. Cell according to one of Claims 1 to 8, <u>characterized</u> in that the current conveyors have biased sources ($I_0$) controlled independently so as to afford the cell a non-linear function.

11. Programmable analogue integrated electronic circuit, <u>characterized</u> in that it comprises:

   . a plurality of analogue elementary cells according to one of Claims 1 to 10 interlinked with one another to form an analogue network, each of the cells comprising active components and resistive and capacitive components of adjustable value so as to afford each cell a transfer function of order 0 or 1;
   . means for adjusting the magnitudes of each capacitive and/or resistive component according to predetermined values.

12. Programmable analogue electronic integrated circuit according to of Claim 11, <u>characterized</u> in that the means for adjusting the magnitudes of each capacitive and/or resistive component to predetermined values consist of:

   - a digital memory (16) containing digital information corresponding to the predetermined values of the capacitive and resistive elements as well as to the state of the bias sources;
   - a digital/analogue converter (18) transforming the data of the digital memory into analogue value;
   - an analogue multiplexer (19) connected to the converter (18), and able to supply the resistive and capacitive elements, and the bias sources of the current conveyors of the elementary cells (12) of the network (15).

13. Programmable analogue electronic integrated circuit according to Claim 11 or 12, <u>characterized</u> in that the means for adjusting the values of each capacitive and resistive component to predetermined values consist of an erasable analogue memory (EEPROM) (20), connected directly to the resistive and capacitive elements, and to the bias sources of the current conveyors of the elementary cells (12) of the network (15).

14. Programmable analogue electronic integrated circuit according to one of Claims 11 to 13, <u>characterized</u> in that the various elementary cells (2) are interlinked according to a matrix network.

15. Programmable analogue electronic integrated circuit according to one of Claims 11 to 13, <u>characterized</u> in that the various elementary cells (2) are interlinked according to a tree-like network.

**Patentansprüche**

1. Analoge, elektronische, unidirektionale Elementarzelle, insbesondere zum Implantieren in einen programmierbaren analogen integrierten Schaltkreis, mit einem Eingangsanschluss (E), einem Ausgangsanschluss (S), **dadurch gekennzeichnet,** dass sie enthält:

   . eine Stromförderstruktur, welche zwei Eingänge (X, Y) und einen Ausgang (Z) aufweist, wobei einer der Eingänge (Y) mit dem Eingangsanschluss (E) der Zelle verbunden ist, wobei der Ausgang (Z) mit dem Ausgangsanschluss (S) der Zelle verbunden ist;
   . zwei parallele RC-Glieder ($R_1,C_1$; $R_2,C_2$), die jeweils einerseits an ein Bezugspotential ($M_1$ bzw. $M_2$) und andererseits an den freien Eingang (X) des Stromförderers bzw. an den Ausgangsanschluss (S) der Zelle angeschlossen ist, wobei die Werte der Widerstände und Kapazitäten ($R_1,C_1$; $R_2,C_2$) auf elektronischem Weg auf vorbestimmte Werte einstellbar sind, um der Zelle eine Übertragungsfunktion der Ordnung 0 oder 1 zu verleihen.

2. Analoge, elektronische, unidirektionale Elementarzelle nach Anspruch 1, **dadurch gekennzeichnet,** dass die Bezugspotentiale $M_1$ und $M_2$ derart angeschlossen sind, dass die Zelle im Gleichtakt arbeitet.

3. Analoge, elektronische, unidirektionale Elementarzelle nach Anspruch 1, **dadurch gekennzeichnet,** dass sie einen zweiten Stromförderer enthält, der es ihr ermöglicht, im Differentialbetrieb zu arbeiten, wobei der Ausgang (Z) des zweiten Stromförderers mit dem Bezugspotential $M_2$ verbunden ist und den negativen Anschluss (S⁻) des Differentialausgangs bildet, wobei einer der Eingänge (X) des zweiten Stromförderers mit dem Bezugspotential ($M_1$) verbunden ist, wobei der andere Eingang (Y) des zweiten Stromförderers den negative Anschluss (E⁻) des Differentialeingangs bildet.

4. Analoge, elektronische, bidirektionale Elementarzelle, insbesondere zum Implantieren in einen programmierbaren analogen integrierten Schaltkreis, **dadurch gekennzeichnet,** dass sie von zwei umgekehrt geschalteten Zellen nach einem der Ansprüche 1 bis 3 gebildet ist, wobei die Eingangsanschlüsse ($E_1$) und die Ausgangsanschlüsse ($S_1$) der ersten Zelle mit den Ausgangsanschlüssen ($S_2$) bzw. den Eingangsanschlüssen ($E_2$) der zweiten Zelle verbunden sind.

5. Zelle nach einem der Ansprüche 1 bis 4, **dadurch gekennzeichnet,** dass einer der einstellbaren Widerstände ($R_1$, $R_2$), , der zwischen seinem unteren Anschluss ($R_1^-$) und seinem oberen Anschluss ($R_1^+$) gemessen wird, durch Verbindung zweier parallel geschalteter und im ohmschen Betrieb arbeitender Transistoren ausgeführt ist, wobei das Gate eines der Transistoren auf ein Steuerpotential ($+V_C$) in Bezug auf den unteren Anschluss ($R_1^-$) des einstellbaren Widerstandes gebracht ist, wobei das Gate des anderen Transistors auf das entgegengesetzte Steuerpotential (-Vc) in Bezug auf den oberen Anschluss ($R_1^+$) des einstellbaren Widerstandes gebracht ist.

6. Zelle nach einem der Ansprüche 1 oder 4, **dadurch gekennzeichnet,** dass einer der einstellbaren Widerstände ($R_1$, $R_2$), der zwischen seinem unteren Anschluss ($R_1^-$) und seinem oberen Anschluss ($R_1^+$) gemessen wird, durch Verbindung zweier in Reihe geschalteter und im ohmschen Betrieb arbeitender Transistoren mit Schwellspannungen ($V_{TOM}$, $V_{TOP}$) ausgeführt ist, wobei der Anschluss eines der Transistoren ($T_3$) mit dem positiven Speisungsanschluss (Vdd) verbunden ist, wobei einer der Anschlüsse des anderen Transistors ($T_4$) mit dem negativen Speisungsanschluss (Vss) verbunden ist, wobei der gemeinsame Punkt zwischen den beiden Transistoren ($T_3$, $T_4$) den positive Anschluss ($R_1^+$) des einstellbaren Widerstandes bildet, wobei das Gate des Transistors ($T_4$) auf ein Steuerpotential (Vn) gebracht ist, wobei das Gate des anderen Transistors auf ein Steuerpotential (Vp) gemäß Vn - Vton = Vp - Vtop gebracht ist.

7. Zelle nach einem der Ansprüche 1 bis 6, **dadurch**

**gekennzeichnet,** dass:

- die einstellbare Kapazität, welche zwischen ihrem oberen Anschluss ($C_1^+$) und ihrem unteren Anschluss ($C_1^-$) gemessen wird, gebildet ist von:

  . einem ersten als Folgeglied geschalteten Stromförderer, dessen einer Eingang mit dem oberen Anschluss ($C_1^+$) der einstellbaren Kapazität verbunden ist;

  . einem zweiten als Stromverstärker geschalteten Stromförderer, dessen:

    - einer Eingang mit dem Ausgang des ersten Stromförderers und mit einem ersten Widerstand ($R_{C1}$) verbunden ist, der selbst mit dem gemeinsamen Potential (M) verbunden ist,
    - anderer Eingang mit einem zweiten Widerstand ($R_{C2}$) verbunden ist, der selbst mit dem gemeinsamen Potential (M) verbunden ist,

  . einer festen Kapazität (C), deren einer Anschluss mit dem unteren Anschluss der einstellbaren Kapazität ($C_1^-$) verbunden ist und deren anderer Anschluss sowohl mit dem Ausgang des zweiten Stromförderers als auch mit dem freien Eingang des ersten Stromförderers verbunden ist;

  und dass einer der mit dem zweiten Stromförderer verbundenen Widerstände ($R_{C1}$, $R_{C2}$) einstellbar und gemäß Anspruch 3 ausgeführt ist.

8. Zelle nach einem der Ansprüche 1 bis 6, **dadurch gekennzeichnet,** dass die einstellbare Kapazität, welche zwischen ihrem oberen Anschluss ($C_1^+$) und ihrem unteren Anschluss ($C_1^-$) gemessen wird, gebildet ist von:

  . einem als Stromverstärker geschalteten Stromförderer, dessen:

    . einer Eingang (X) mit einem ersten Widerstand ($R_1$) verbunden ist, der selbst mit dem gemeinsamen Potential (M) verbunden ist,
    . Ausgang (Z) mit einem zweiten Widerstand ($R_2$) verbunden ist, der selbst mit dem gemeinsamen Potential (M) verbunden ist,
    . Eingang (Y) mit dem oberen Anschluss ($C_1^+$) der einstellbaren Kapazität verbunden ist,

  . einer festen Kapazität (C), deren einer Anschluss mit dem oberen Anschluss ($C_1^+$) der einstellbaren Kapazität verbunden ist und dessen anderer Anschluss mit dem Ausgang (Z) des Stromförderers verbunden ist.

9. Zelle nach einem der Ansprüche 1 bis 8, **dadurch gekennzeichnet,** dass die Stromförderer Vorspannungsquellen ($I_0$) aufweisen, die gleichzeitig gesteuert werden, um der Zelle eine Leerlaufschaltungs- oder Kurzschlussfunktion zu verleihen.

10. Zelle nach einem der Ansprüche 1 bis 8, **dadurch gekennzeichnet,** dass die Stromförderer Vorspannungsquellen ($I_0$) aufweisen, die unabhängig voneinander gesteuert werden, um der Zelle eine nichtlineare Funktion zu verleihen.

11. Programmierbarer, analoger, elektronischer, integrierter Schaltkreis, **dadurch gekennzeichnet,** dass er enthält:

  • eine Vielzahl von analogen Elementarzellen ausgeführt nach einem der Ansprüche 1 bis 10, die miteinander verbunden sind, um ein analoges Netz zu bilden, wobei jede Zelle aktive Bauelemente sowie resistive und kapazitive Bauelemente mit einstellbarem Wert enthält, um jeder Zelle eine Übertragungsfunktion der Ordnung 0 oder 1 zu verleihen;
  • Mittel zum Einstellen der Größen jedes kapazitiven und/oder resistiven Bauelements entsprechend vorbestimmter Werte.

12. Programmierbarer, analoger, elektronischer, integrierter Schaltkreis nach Anspruch 11, **dadurch gekennzeichnet,** dass die Mittel zum Einstellen der Größen jedes kapazitiven und/oder resistiven Bauelements auf vorbestimmte Werte gebildet sind von:

  - einem digitalen Speicher (16), welcher digitale Informationen enthält, die den vorbestimmten Werten der kapazitiven und resistiven Bauelemente sowie dem Zustand der Vorspannungsquellen entsprechen;
  - einem Digital-Analog-Wandler (18), der die Daten aus dem digitalen Speicher in analoge Werte umwandelt;
  - einem analogen Multiplexer (19), der mit dem Wandler (18) verbunden ist und die resistiven und kapazitiven Bauelemente sowie die Vorspannungsquellen der Stromförderer der Elementarzellen (12) des Netzes (15) speisen kann.

13. Programmierbarer, analoger, elektronischer, integrierter Schaltkreis nach einem der Ansprüche 11 oder 12, **dadurch gekennzeichnet,** dass die Mittel zum Einstellen der Werte jedes kapazitiven und resistiven Bauelements auf vorbestimmte Werte von einem löschbaren Analogspeicher (EEPROM) (20) gebildet sind, der direkt mit den resistiven und kapazitiven Bauelementen und mit den Vorspannungsquellen der Stromförderer der Elementarzellen (12) des Netzes (15) verbunden ist.

14. Programmierbarer, analoger, elektronischer, integrierter Schaltkreis nach einem der Ansprüche 11 bis 13, **dadurch gekennzeichnet,** dass die verschiedenen Elementarzellen (2) entsprechend einer Matrixschaltung miteinander verbunden sind.

15. Programmierbarer, analoger, elektronischer, integrierter Schaltkreis nach einem der Ansprüche 11 bis 13, **dadurch gekennzeichnet,** dass die verschiedenen Elementarzellen (2) entsprechend einer baumartigen Schaltung miteinander verbunden sind.

*FIG 1*

*FIG 2*

**FIG 3**

**FIG 4**

**FIG 5**

**FIG 6**

**FIG 7**

**FIG 8**

**FIG 9**

**FIG 10**

*FIG  11*

*FIG  12*

*FIG 13*

*FIG 14*

*FIG 15*